(19) **Europäisches Patentamt**
**European Patent Office**
**Office européen des brevets**

(11) **EP 1 633 050 B1**

(12) **EUROPEAN PATENT SPECIFICATION**

(45) Date of publication and mention
of the grant of the patent:
**20.08.2008  Bulletin 2008/34**

(51) Int Cl.:
***H03M 1/00*** *(2006.01)*

(21) Application number: **04292152.8**

(22) Date of filing: **07.09.2004**

(54) **Analog/digital conversion with adjustable thresholds**

Analog/Digital-Wandler mit einstellbaren Schwellwerten

Convertisseur analogique/numérique à seuils réglables

(84) Designated Contracting States:
**AT BE BG CH CY CZ DE DK EE ES FI FR GB GR HU IE IT LI LU MC NL PL PT RO SE SI SK TR**

(43) Date of publication of application:
**08.03.2006  Bulletin 2006/10**

(73) Proprietor: **Alcatel Lucent**
**75008 Paris (FR)**

(72) Inventors:
• **Franz, Bernd**
**74336 Brackenheim (DE)**
• **Buchali, Fred**
**71336 Waiblingen (DE)**
• **Bülow, Henning**
**70806 Kornwestheim (DE)**

(74) Representative: **Schmidt, Werner Karl**
**Alcatel-Lucent**
**Intellectual Property & Standards**
**70430 Stuttgart (DE)**

(56) References cited:
WO-A-02/082694 US-A- 5 159 609
US-A1- 2002 122 503 US-A1- 2004 032 914
US-A1- 2004 057 512 US-B1- 6 275 959

• YU-JHIH WU ET AL: "An Adaptive Soft-decision Quantizer For Digital Communications With Convolutional Coding On A Rayleigh Fading Channel" IEEE, vol. 1, 25 October 1993 (1993-10-25), pages 447-450, XP010301935
• FORNEY G D: "THE VITERBI ALGORITHM" PROCEEDINGS OF THE IEEE, IEEE. NEW YORK, US, vol. 61, no. 3, 1 March 1973 (1973-03-01), pages 268-278, XP000573242 ISSN: 0018-9219
• SANER-GREFF W ET AL: "Maximum-likelihood sequence estimation in nonlinear optical transmission systems" 26 October 2003 (2003-10-26), LEOS 2003. 16TH. ANNUAL MEETING OF THE IEEE LASERS & ELECTRO-OPTICS SOCIETY. TUCSON, AZ, OCT. 27 - 28, 2003, ANNUAL MEETING OF THE IEEE LASERS AND ELECTRO-OPTICS SOCIETY, NEW YORK, NY : IEEE, US, PAGE(S) 167-168 , XP010676397 ISBN: 0-7803-7888-1 * abstract *

## Description

Background of the invention

The invention relates to a device for receiving a distorted signal, in particular an optical signal converted by an opto/electrical converter, comprising an analog/digital converter with adjustable thresholds and a Viterbi equalizer.

Digital optical signals traversing an optical fiber link are subject to distortion and noise which may produce bit errors at the receiver side. At higher transmission rates or longer span lengths, error correction may thus be performed at the receiver side to reduce the error rate of distorted signals. A known method of error correction, the Maximum Likelihood Sequence Estimation (MLSE) reducing errors caused by inter-symbol interference (ISI), uses a Viterbi equalizer. Viterbi equalizers require analog to digital conversion of received optical signals after signal detection in a photodiode.

Most analog to digital converters (ADC) follow a linear scale, i.e. the scale for a given bit resolution is subdivided in equidistant steps per bit. Optical noise, however, is signal dependent and therefore the optimum characteristic of the analog-to-digital converter (ADC) is not necessarily linear.

High speed ADC of 10-40 Gb/s data signals suffer from technological constraints. Therefore only 3 bit or 4 bit resolution can be used. On the other hand, in particular with low noise and distortions, i.e. at a low bit-error-ratio, a small number of thresholds can result in a significant higher bit-error-ratio.

This results in only roughly estimated channel parameters and therefore not optimum operation.

US 6,417,965 discloses an optical amplifier control system that uses a non-linear analog-to-digital converter with a logarithmic scale but does not show an implementation of such an ADC.

The article "Maximum-Likelihood Sequence Estimation in Nonlinear Optical Transmission Systems" by W.Sauer-Greff et al., IEEE, 2003, pages 167-168, discloses an optical transmission system including an ADC and an adaptive Viterbi equalizer for mitigating non-linear intersymbol interference.

WO 02/082694 discloses a multilevel optical receiver comprising a plurality of comparators that generally correspond to the number of levels of a multilevel data stream. Each comparator can be individually controlled and a decision threshold can be set in order to decode a multilevel signal. The multilevel optical receiver can generate a statistical characterization of the received symbols in the form of a marginal cumulative distribution function or probability density function. This characterization can be used to produce a set of estimates from which conditional probability density functions are derived for each of the transmission symbols. These conditional probability density functions may then be used to determine decision thresholds for decoding the received signal.

Object of the invention

It is the object of the invention to provide a device of the above-mentioned kind in which for a given number of thresholds a bit-error-ratio is minimized.

Brief description of the invention

This object is achieved by a device which comprises a histogram estimator for determining a probability density function of the distorted signal and a threshold estimator for dynamically adjusting at least one threshold of the analog/digital converter in an overlap region of a first signal amplitude attributed to a first symbol and a second signal amplitude attributed to a second symbol of the probability density function, wherein the threshold is set such that a ratio of symbol counts in a first quantization stage is equal to a reciprocal ratio of symbol counts in a second, adjacent quantization stage, wherein the ratio of symbol counts in the first quantization stage is defined by a quotient of a number of bit counts attributed to the first symbol and a number of bit counts attributed to the second symbol.

Symbols are defined by a number of channel parameters. Among these, the expected values and their standard deviation are the most relevant.

The above adaptation of ADC threshold levels sets these levels to relevant points in the voltage distribution of the distorted electrical signal, such that an optimized analog/digital conversion for further signal processing is possible. The invention is particularly suited for low resolution ADC (3-4 bit) and may be applied to receivers in systems with significant signal distortion which has to be mitigated and in systems which are operated close to noise limit.

In a preferred embodiment, a lower threshold is set in a first overlap region, an upper threshold is set in a second overlap region, a first supplementary threshold is set below the lower threshold, a second supplementary threshold is set above the upper threshold, and the remaining thresholds are set in between the lower threshold and the upper threshold. The upper and lower thresholds limit the range in which the quantization stages of the analog/digital converter are set. This range can be considerably smaller than the overall dynamic range of the analog/digital converter and of the data signal.

In a preferred embodiment, the histogram estimator comprises a comparator for determining a cumulative voltage distribution of the distorted signal by comparing the distorted signal with a varying threshold signal. In this way, the cumulative voltage distribution can be easily obtained. The probability density function can be determined by derivation of the cumulative voltage distribution after averaging.

In a further preferred embodiment the threshold signal is a finely quantized saw-tooth voltage generated in a counter and converted to an analog signal by a digital/ analog converter. The finely quantized saw-tooth voltage covers the whole dynamic range of the ADC.

In another preferred embodiment, the histogram estimator comprises an averaging means for averaging the cumulative density function of the distorted signal. The averaging can be achieved by using a low-pass filter.

In a further preferred embodiment, the histogram estimator comprises a voltage histogram determination means for determining the probability density function as a derivative of the averaged cumulative density function. The probability density function, also called voltage histogram, yields the probability density of voltage values over the dynamic range of the analog/digital converter. Knowledge of this distribution allows to determine relevant regions of the distorted signal.

In another preferred embodiment, a parameter estimation means for estimating channel parameters of the Viterbi equalizer is provided. The parameter estimation means uses the probability density function for the determination of the channel parameters of the Viterbi equalizer. Precisely estimated channel parameters are crucial to ensure a low bit-error-ratio of the Viterbi equalizer.

Further advantages may be extracted from the description and the enclosed drawings. The features mentioned above and below may be used in accordance with the invention either individually or collectively in any combination. The embodiments mentioned are not to be understood as an exhaustive enumeration but rather have an exemplary character for the

description of the invention.

Drawings

The invention is shown in the drawings, wherein:

Fig. 1     shows a circuit diagram of a device according to the invention,

Fig. 2     shows a circuit diagram of a state-of-the art analog/digital converter,

Fig. 3     shows three signal amplitudes attributed to three symbols with two overlap regions and five threshold levels,

Fig. 4     shows a comparator output signal in dependence of the voltage of a distorted signal and a finely quantized saw-tooth voltage,

Fig. 5     shows a cumulative distribution function of the voltage of the distorted signal after averaging, and

Fig. 6     shows a probability density function of the distorted signal after building the histogram.

Description of preferred embodiments

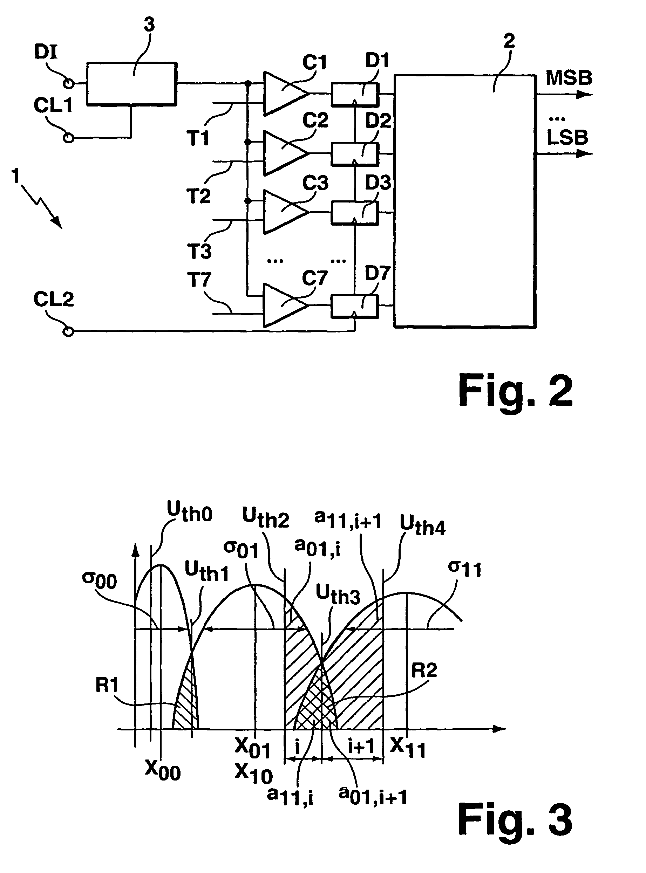

**Fig. 2** shows a state-of-the-art analog/digital converter **1** with three bit conversion. The analog signal to be converted is applied to a signal input **DI**. A sample-and-hold (S&H) circuit **3** samples the analog value and holds it for one clock period of a clock signal input **CL1** (clock related issues are not shown in the circuit diagram but would be apparent to and could thus easily be added by those skilled in the art). The sampled value is then compared to external threshold values from threshold inputs **T1** through **T7** in comparators **C1** through **C7** which are arranged in parallel. Output signals of the compensators C1 through C7 are then used as an input to D-flip-flops **D1** through **D7** which are connected to a common clock input **CL2**. Output signals of the D-flip-flops D1 through D7 are used as input signals for a linear to binary encoder **2** which creates a three-bit digital output signal.

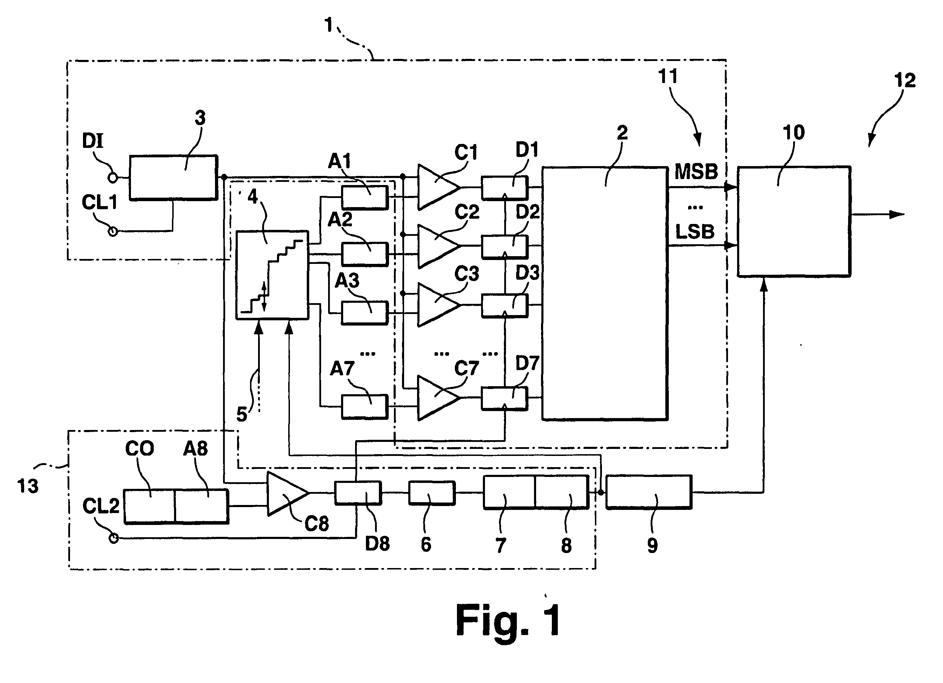

**Fig. 1** shows the state-of the-art analog/digital converter 1 of Fig. 2 as part of a device which comprises some additional components for the fixation of threshold levels, in particular a threshold estimator **4** and a histogram estimator **13**. The threshold estimator 4 fixes digital vaiues for threshold levels. These digital values are converted to analog signals in digital/analog converters **A1** through **A7** and are used as threshold inputs for the comparators C1 through C7.

The threshold estimator 4 is provided with the probability density function of the distorted signal of the signal input DI. Thresholds are adapted in such a way that a bit-error-ratio of a subsequent Viterbi equalizer **10** is optimized, as described below. The Viterbi equalizer 10 receives a first digital bit signal **11** from the analog/digital converter 1 as an input and provides an equalized digital one-bit signal **12** as an output.

For determining the regions of the probability density function in which thresholds are most advantageously set, the threshold estimator 4 is provided with a connection means **5** for being connected to a forward error correction means (FEC, not shown). The bit-error-ratio of the FEC can be used to identify relevant voltage values of the probability density function.

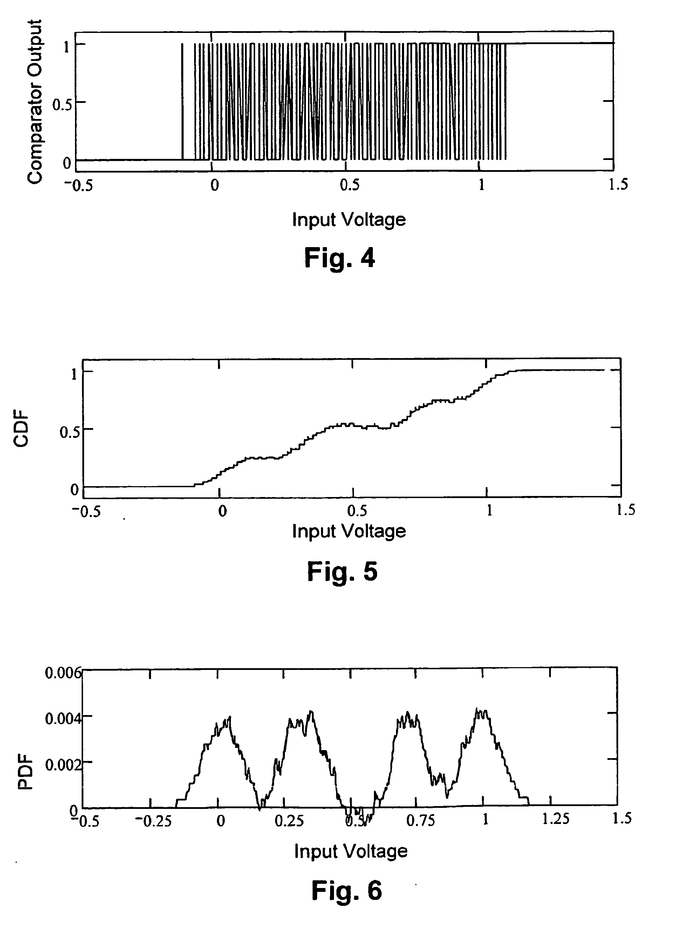

In order to obtain the probability density function, the input signal from the sample-and-hold circuit 3 is compared with a varying threshold signal in a comparator **C8** of the histogram estimator 13. The varying threshold signal, a finely quantized saw-tooth voltage, is generated in a counter **CO** and converted into an analog signal in a digital/analog converter **A8**. For a noisy polarization mode distorted input data signal with $\Gamma = 0.3$, the output signal of the converter C8 is shown in **Fig. 4**.

Since the statistics of the input signal is only slowly varying, the probability distribution function, i.e. the cumulative distribution function, can be obtained by averaging the output signal of C8. Therefore, after passing through a D-flip-flop **D8,** the signal is averaged in a low-pass filter **6** and then passed on to a high-resolution analog/digital converter **7.** Since the signal is averaged over a large number of data bits a low speed ADC 7 can be taken.

**Fig. 5** shows the output signal of the ADC 7, namely the cumulative distribution function CDF of the distorted input signal determined with six bit resolution. The derivative of the CDF is the probability density function PDF. This function is obtained by differentiation of the CDF in a voltage histogram determination means **8,** whose output signal, shown in **Fig. 6,** is used as an input signal to the threshold estimator 4. Further digital computation in the threshold estimator 4 delivers the ADC thresholds with high accuracy, as described below. Using the PDF of the averaged distorted signal, channel model parameters of the Viterbi equalizer 10 can be determined by a parameter estimation means **9** and provided as an input for the Viterbi equalizer 10.

In the example shown in Fig. 6, four peaks in the PDF can be identified corresponding to four symbols. For each peak, an expected value **X** and a standard deviation $\sigma$ of a symmetrical Gaussian-like distribution can be obtained. Of course, other approximating distributions such as exponential functions, may be used for attributing parts of the probability density function to specific symbols. For the sake of simplicity, only symmetrical distributions will be considered in the following, although optical preamplified signals have signal dependent noise contributions leading to a more noisy "1" compared to "0". A further adaptation to unsymmetrical noise is therefore advantageous, but is a straightforward matter for those skilled in the art.

**Fig. 3** shows a probability density function of the distorted signal of the data input DI with three symbols corresponding to bit combinations {0,0}, {0,1}, {1,0} and {1,1}. Two of these bit combinations, namely {0,1} and {1,0}, are combined to constitute a first symbol.

The first symbol is defined by a first expected value **$X_{01}$** coinciding with **$X_{10}$** and a standard deviation $\sigma_{10}$ coinciding with $\sigma_{01}$. A second and third symbol are defined by an expectation value of **$X_{11}$** resp. **$X_{00}$** and a standard deviation $\sigma_{11}$ resp. $\sigma_{00}$. The first and the second symbol overlap in a second region **R2**. The first and the third symbol overlap in a first region **R1**.

In the threshold estimator 4, an upper threshold $U_{th3}$ is set in the second region R2 at an intersection point of the first symbol with the second symbol. A lower threshold $U_{th1}$ is set at an intersection point of the first symbol with the third symbol. A first supplementary threshold $U_{th0}$ is set below the lower threshold $U_{th1}$ and a second supplementary threshold $U_{th4}$ is set above the upper threshold $U_{th3}$. The remaining number of thresholds of the analog/digital converter 1 is set in between the lower threshold $U_{th1}$ and the upper threshold $U_{th3}$, as this region is identified to be the most relevant part of the dynamic range of the analog/digital converter 1. Therefore a high number of threshold levels is placed between the upper and the lower thresholds $U_{th1}$ and $U_{th3}$, of which only one threshold $U_{th2}$ is exemplarily shown.

The thresholds between the lower and upper thresholds $U_{th1}$ and $U_{th3}$ may be set in equidistant stages. For more complicated power density functions with more than three symbols, some of the threshold levels between the upper and lower thresholds $U_{th1}$ and $U_{th3}$ may be fixed in the way described above.

The determination of threshold levels is possible by using intersection points of symbols. However, it is also possible to determine threshold levels with a procedure described in the following, exemplarily explained for the upper threshold level $U_{th3}$. This method is advantageously applied in cases when intersection points are not known precisely, for example when channel parameters are not known with high accuracy.

The starting point of the method is to define a first quantization stage i and a second, adjacent quantization stage **i+1** between which the threshold level $U_{th3}$ has to be fixed. In the first stage i, a number of bit counts **$a_{01,i}$** attributed to the first symbol defined by channel parameters $\sigma_{01}$, $X_{01}$, represented in Fig. 3 as a hatched region in stage i between thresholds $U_{th2}$ and $U_{th3}$, and a number of bit counts **$a_{11,i}$** attributed to the second symbol defined by channel parameters $\sigma_{11}$, $X_{11}$ represented in Fig. 3 as a crosshatched region in stage i, are determined.

Likewise, a number of bit counts **$a_{01,i+1}$** attributed to the first symbol in stage i+1 and a number of bit counts **$a_{11,i+1}$** attributed to the second symbol in stage i+1 are determined. The upper threshold $U_{th3}$ is determined in such a way that the following formula holds:

$$a_{01,i} \,/\, a_{11,i} = a_{11,i+1} \,/\, a_{01,i+1} \,.$$

The above formula may also be rewritten in the following form:

$$a_{01,i} \cdot a_{01,i+1} = a_{11,i+1} \cdot a_{11,i} \,.$$

The above reformulation makes clear that a threshold level between the first stage i and the second stage i+1 is set such that products of bit counts attributed to a specific symbol in the first stage i and the second stage i+1 are equal. It is to be understood that the upper threshold $U_{th3}$ shown in Fig. 3 has only exemplary character and does not satisfy the above relation.

In summary, the invention makes available adapted threshold levels of an analog/digital converter and as well channel parameters of a Viterbi equalizer with high resolution. Evaluation of the voltage histogram of the input data signal with high resolution is possible. The adaptation of ADC threshold levels increases the resolution in significant amplitude regions, whereas non significant regions have reduced resolutions. Therefore, the invention increases performance of receivers with low resolution ADC.

## Claims

1. Device for receiving a distorted optical signal converted by an opto/electrical converter, comprising: an analog/digital converter (1) with adjustable thresholds, a histogram estimator (13) for determining a probability density function of the distorted signal and a threshold estimator (4) for dynamically adjusting at least one threshold ($U_{th1}$) of the analog/digital converter (1) in an overlap region ($R_1$) of a first signal amplitude attributed to a first symbol ($\sigma_{10}$, $X_{10}$) and a second signal amplitude attributed to a second symbol ($\sigma_{11}$, $X_{11}$) of the probability density function, **characterized in that** the device further comprises a Viterbi equalizer (10), and **in that** at least one threshold ($U_{th1}$) is set such that a ratio ($a_{01,i}$ / $a_{11,i}$) of symbol counts in a first quantization stage (i) is equal to a reciprocal ratio ($a_{11,i+1}$ / $a_{01,i+1}$) of symbol counts in a second, adjacent quantization stage (i+1), wherein the ratio ($a_{01,i}$ / $a_{11,i}$) of symbol counts in the first quantization stage (i) is defined by a quotient of a number of bit counts ($a_{01,i}$) attributed to the first symbol ($\sigma_{10}$, $X_{10}$) and a number of bit.counts ($a_{11,i}$) attributed to the second symbol ($\sigma_{11}$, $X_{11}$).

2. Device according to claim 1, **characterized in that** a lower threshold ($U_{th1}$) is set in a first overlap region ($R_1$), an upper threshold ($U_{th3}$) is set in a second overlap region ($R_2$), a first supplementary threshold ($U_{th0}$) is set below the lower threshold ($U_{th1}$), a second supplementary threshold ($U_{th4}$) is set above the upper threshold ($U_{th3}$) and the remaining thresholds ($U_{th2}$) are set in between the lower threshold ($U_{th1}$) and the upper threshold ($U_{th3}$).

3. Device according to claim 1, **characterized in that** the histogram estimator (13) comprises a comparator (C8) for determining a cumulative voltage distribution of the distorted signal by comparing the distorted signal with a varying threshold signal.

4. Device according to claim 3, **characterized in that** the varying threshold signal is a finely quantized sawtooth voltage generated in a counter (CO) and converted to an analog signal by a digital/analog converter (A8).

5. Device according to claim 3, **characterized in that** the histogram estimator (13) comprises an averaging means (6) for averaging the cumulative density function of the distorted signal.

6. Device according to claim 3, **characterized in that** the histogram estimator (13) comprises a voltage histogram determination means (8) for determining the probability density function as a derivative of the averaged cumulative density function.

7. Device according to claim 1; **characterized by** a parameter estimation means (9) for estimating channel parameters of the Viterbi equalizer (10).

## Patentansprüche

1. Vorrichtung zum Empfangen eines von einem opto-elektrischen Wandler konvertierten verzerrten optischen Signals, welche umfasst: einen Analog-Digital-Umsetzer (1) mit regelbaren Schwellen, einen Histogramm-Schätzer (12) zum Ermitteln einer Wahrscheinlichkeitsdichtefunktion des verzerrten Signals, und einen Schwellenschätzer (4) zum dynamischen Justieren von mindestens einer Schwelle ($U_{th1}$) des Analog-Digital-Umsetzers (1) in einer Überlappungsregion ($R_1$) einer ersten Signalamplitude, welche einem ersten Symbol ($\sigma_{10}$, $X_{10}$) zugeordnet wird, und einer zweiten Signalamplitude, welche einem zweiten Symbol ($\sigma_{11}$, $X_{11}$) der Wahrscheinlichkeitsdichtefunktion zugeordnet wird, **dadurch gekennzeichnet, dass** die Vorrichtung weiterhin einen Viterbi-Equalizer (10) umfasst, und **dadurch**, dass mindestens eine Schwelle ($U_{th1}$) so gesetzt ist, dass eine Ratio ($a_{01,l}$ / $a_{11,l}$) von Symbolanzahlen in einer ersten Quantisierungsstufe (i) gleich einer reziproken Ratio ($a_{11,l+1}$ / $a_{01,i+1}$) von Symbolanzahlen in einer zweiten, benachbarten Quantisierungsstufe (i+1) ist, wobei die Ratio ($a_{01,l}$ / $a_{11,l}$) von Symbolanzahlen in der ersten Quantisierungsstufe (i) von einem Quotienten einer Anzahl von Bits ($a_{01,l}$), welche dem ersten Symbol ($\sigma_{10}$, $X_{10}$) zugeordnet wird, und einer Anzahl von Bits ($a_{11,l}$), welche dem zweiten Symbol ($\sigma_{11}$, $X_{11}$) zugeordnet wird, definiert wird.

2. Vorrichtung nach Anspruch 1, **dadurch gekennzeichnet, dass** eine untere Schwelle ($U_{th1}$) in einer ersten Überlappungsregion ($R_1$), eine obere Schwelle ($U_{th3}$) in einer zweiten Überlappungsregion ($R_1$), eine erste zusätzliche Schwelle ($U_{th0}$) unter der unteren Schwelle ($U_{th1}$), eine zweite zusätzliche Schwelle ($U_{th4}$) Ober der oberen Schwelle ($U_{th3}$) und die restlichen Schwellen ($U_{th2}$) zwischen der unteren Schwelle ($U_{th1}$) und der oberen Schwelle ($U_{th3}$) gesetzt werden.

3. Vorrichtung nach Anspruch 1, **dadurch gekennzeichnet, dass** der Histogramm-Schätzer (13) einen Komparator (C8) zum Ermitteln einer kumulierten Spannungsverteilung des verzerrten Signals durch Vergleichen des verzerrten Signals mit einem variablen Schwellensignal umfasst.

4. Vorrichtung nach Anspruch 3, **dadurch gekennzeichnet, dass** das variable Schwellensignal eine fein quantisierte Sägezahnspannung, welche in einem Zähler (CO) erzeugt und von einem Digital-Analog-Umsetzer (A8) in ein Analogsignal konvertiert wird, ist.

5. Verfahren nach Anspruch 3, **dadurch gekennzeichnet, dass** der Histogramm-Schätzer (13) Mittelungsmittel (6) zum Mitteln der kumulierten Dichtefunktion des verzerrten Signals umfasst.

6. Verfahren nach Anspruch 3, **dadurch gekennzeichnet, dass** der Histogramm-Schätzer (13) ein Mittel zur Ermittlung des Spannungshistogramms (8) zum Bestimmen der Wahrscheinlichkeitsdichtefunktion als eine Ableitung der gemittelten kumulierten Dichtefunktion umfasst.

7. Verfahren nach Anspruch 1, **gekennzeichnet durch** ein Parameterschätzungsmittel (9) zum Schätzen der Kanalparameter des Viterbi-Equalizers (10).

**Revendications**

1. Dispositif pour recevoir un signal optique déformé converti par un convertisseur opto-électrique comprenant : un convertisseur analogique/numérique (1) avec des seuils réglables, un dispositif d'estimation de l'histogramme (13) pour déterminer une fonction de densité de probabilité du signal déformé et un dispositif d'estimation du seuil (4) pour régler dynamiquement au moins un seuil ($U_{th1}$) du convertisseur analogique/numérique (1) dans une région de chevauchement ($R_1$) d'une première amplitude de signal attribuée à un premier symbole ($\sigma_{10}$, $X_{10}$) et une deuxième amplitude de signal attribuée à un deuxième symbole ($\sigma_{11}$, $X_{11}$) de la fonction de densité de probabilité, **caractérisé en ce que** le dispositif comprend en plus un égaliseur de Viterbi (10) et **en ce qu'**au moins un seuil ($U_{th1}$) est réglé de telle sorte qu'un rapport ($a_{01,l}$, $a_{11,l}$) de nombres de symboles dans une première étape quantification (i) est égal à un rapport inverse ($a_{11,i+1}$, $a_{01,l+1}$) de nombres de symboles dans un deuxième étape de quantification (i+1) voisine, le rapport ($a_{01,i}$, $a_{11,i}$) de nombres de symboles dans la première étape de quantification (i) étant défini par un quotient d'un nombre de bits ($a_{01,i}$) attribué au premier symbole ($\sigma_{10}$, $X_{10}$) et d'un nombre de bits ($a_{11,i}$) attribué au deuxième symbole ($\sigma_{11}$, $X_{11}$).

2. Dispositif selon la revendication 1, **caractérisé en ce qu'**un seuil inférieur ($U_{th1}$) est réglé dans une première région de chevauchement ($R_1$), un seuil supérieur ($U_{th3}$) est réglé dans une deuxième région de chevauchement ($R_2$), un premier seuil supplémentaire ($U_{th0}$) est réglé au-dessous du seuil inférieur ($U_{th1}$), un deuxième seuil supplémentaire ($U_{th4}$) est réglé au-dessus du seuil supérieur ($U_{th3}$) et les seuils restants ($U_{th2}$) sont réglés entre le seuil inférieur ($U_{th1}$) et le seuil supérieur ($U_{th3}$).

3. Dispositif selon la revendication 1, **caractérisé en ce que** le dispositif d'estimation de l'histogramme (13) comprend un comparateur (C8) pour déterminer une distribution de tension cumulative du signal déformé en comparant le signal déformé avec un signal de seuil qui varie.

4. Dispositif selon la revendication 3, **caractérisé en ce que** le signal de seuil qui varie est une tension en dents de scie quantifiée avec précision générée dans un compteur (CO) et convertie en un signal analogique par un convertisseur numérique/analogique (A8).

5. Dispositif selon la revendication 3. **caractérisé en ce que** le dispositif d'estimation de l'histogramme (13) comprend un moyen de calcul de la moyenne (6) pour calculer la moyenne de la fonction de densité cumulative du signal déformé.

6. Dispositif selon la revendication 3, **caractérisé en ce que** le dispositif d'estimation de l'histogramme (13) comprend un moyen de détermination de l'histogramme (8) pour déterminer la fonction de densité de probabilité en fonction d'une dérivée de la moyenne calculée de la fonction de densité cumulative.

7. Dispositif selon la revendication 1, **caractérisé par** un moyen d'estimation des paramètres (9) pour estimer les paramètres de canal de l'égaliseur de Viterbi (10).

Fig. 1

EP 1 633 050 B1

EP 1 633 050 B1

Fig. 2

Fig. 3

Fig. 4

Fig. 5

Fig. 6

# REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 6417965 B

- WO 02082694 A

**Non-patent literature cited in the description**

- **W.SAUER-GREFF et al.** Maximum-Likelihood Sequence Estimation in Nonlinear Optical Transmission Systems. *IEEE,* 2003, 167-168